# EUROPEAN PATENT APPLICATION

(11) **EP 2 501 009 A1**
(43) Date of publication of application: **19.09.2012**
(21) Application number: 12000799.2
(22) Date of filing: 07.02.2012
(51) Int. Cl.: H02H 7/06, G01R 31/34

(54) **Electric rotating machine**

(30) Priority: 10.03.2011 JP 2011052344
(71) Applicant: HITACHI, LTD., Tokyo 100-8280 (JP)
(72) Inventor: Nakahara, Akihito, Tokyo 100-8220 (JP); Okada, Masayuki, Tokyo 100-8220 (JP); Kayukawa, Shigehiro, Tokyo 100-8220 (JP)
(74) Representative: Strehl Schübel-Hopf & Partner

(57) **Abstract**

This invention aims to provide an electric rotating machine (1) which is free from the procedure of selecting different preset neutral current values for different types of machines, and which can detect a ground fault in a phase coil of the armature winding without suffering any erroneous operation. An electric rotating machine (1) having an armature winding including three phase coils, which has been provided to attain the object of this invention, comprises a grounding resistor (10) connected at a neutral of the armature winding, and current measuring apparatuses (2) furnished for at least two phase coils, wherein phase currents through the phase coils are compared with each other, and the detection of a coil ground fault is determined when harmonic components of the phase currents differ from each other.

## Description

### FIELD OF THE INVENTION

This invention relates to an electric rotating machine which can detect a ground fault occurring in a phase coil of the armature winding and therefore protect itself from the ground fault.

### BACKGROUND OF THE INVENTION

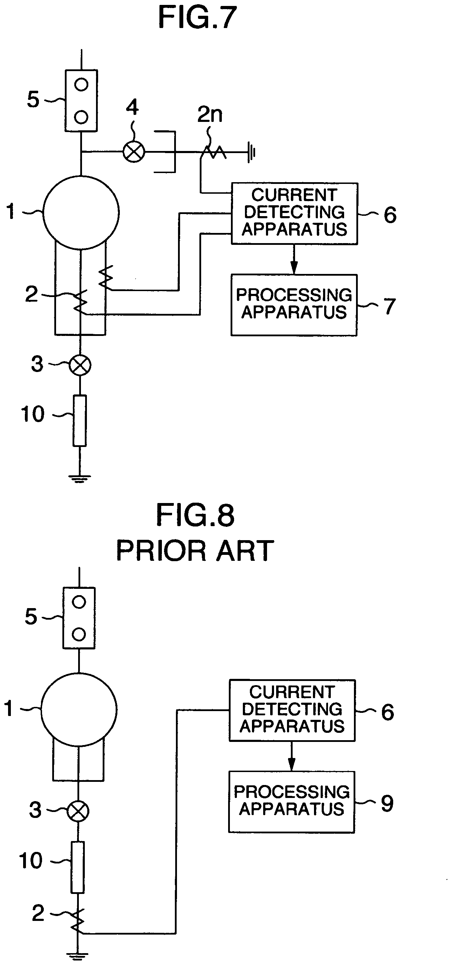

In general, the fact that a ground fault has occurred in the armature winding of an electric rotating machine is determined by comparing the current through the neutral in the armature winding at the time of the ground fault taking place with a preset value or a modified version of the preset value adjusted depending on the output, etc. Fig. 8 is a wiring diagram for an example of a conventional electric rotating machine capable of detecting a ground fault. In an electric rotating machine 1, the three phase coils of the armature winding are connected together to form a neutral, and the neutral is grounded via a disconnector 3 and a neutral grounding resistor 10. And a current measuring apparatus 2 measures the neutral current. The measured current is then detected by a current detecting apparatus 6, and thereafter a processing apparatus 9 compares the detected current with a preset value. If the value of the current subjected to the comparison falls outside the predetermined range of soundness, it is determined that a ground fault has occurred in a phase coil.

Examples of conventional techniques for protecting an electric rotating machine from a ground fault occurring in a phase coil of the armature winding are disclosed in such patent documents as JP-A-59-25529, JP-A-59-10127, JP-A-2005-33877, and JP-A-03-36920.

All these techniques concentrate on the fact that the current flowing through the neutral changes when a ground fault occurs in a phase coil. These techniques are briefly described below.

According to JP-A-59-25529, an erroneous operation, which may occur when the protective mechanism is applied over the entire range of the generator output, is prevented by detecting the fundamental current varying in proportion to the generator output and then calculating the third harmonic component.

According to JP-A-59-10127, the operating threshold of the ground fault protection relay is changed depending on the fundamental current in order to cope with a ground fault at a point of low potential.

According to JP-A-2005-33877, in the case where a generator is used to start up a generator system in a gas-turbine power generating plant as an induction machine, a harmonic current detecting apparatus and a neutral side ground fault protection relay are furnished in parallel with a neutral grounding resistor; a fuse is furnished between the neutral grounding resistor and the harmonic current detecting apparatus; and the third harmonic current at the time of a neutral side ground fault taking place is detected to protect the generator.

According to JP-A-03-36920, comparison is made between the third harmonic estimated on the basis of the inputted state variables that influence the third harmonic voltage of the electric rotating machine and the third harmonic component of the detected voltage corresponding to the neutral current that is obtained through conversion in the neutral grounding apparatus; and a protecting operation is performed when predetermined conditions are satisfied as the measured value approaches the estimated value.

However, all these techniques must resort to the comparison between the preset value and the measured value. As a result, it is required to select different preset values for the neutral current used to determine a ground fault if the techniques are applied to different types of electric rotating machines. Further, even if the output of the electric rotating machine and the harmonic current are measured and even if the measured output and current are properly processed, it is still required to continuously measure the change in the neutral current from its value assumed when the electric rotating machine is sound. Therefore, these conventional methods can be applied only to the case where the electric rotating machine is operating free from an erroneous operation.

Further, when the electric brake used for a generator-motor is actuated, the armature current cancels the electric motive forces induced in the phase coils of the armature so that the change in the neutral current through the neutral grounding apparatus and the change in the voltage resulted from the conversion of the neutral current are both small. Accordingly, it is considered that the detection of a ground fault by these techniques is difficult.

### SUMMARY OF THE INVENTION

As described above, all the conventional methods of detecting ground faults must resort to the comparison between the preset value and the measured value. As a result, it is required to select different preset values for the neutral current used to determine a ground fault if the techniques are applied to different types of electric rotating machines. Also, even if the output of the electric rotating machine and the harmonic current are measured so that the measured output and current are properly processed, it is still required to continuously measure the change in the neutral current from its value assumed when the electric rotating machine is sound. Therefore, these conventional methods can be applied only to the case where the electric rotating machine is operating free from an erroneous operation.

Further, when the electric brake used for a generator-motor is actuated, the armature current cancels the electric motive forces induced in the phase coils of the armature so that the change in the neutral current through the neutral grounding apparatus and the change in the voltage resulted from the conversion of the neutral current are both small. Accordingly, there was a problem that the detection of a ground fault by these methods is difficult.

The object of this invention, which has been made to solve the above mentioned problem, is to provide an electric rotating machine which is free from the procedure of selecting different preset neutral current values for different types of machines, which can detect a ground fault in a phase coil of the armature winding without suffering any erroneous operation, and which can detect a ground fault in a phase coil of the armature winding even when electric brake is being actuated.

In order to attain the object mentioned above, according to this invention, there is provided an electric rotating machine having an armature winding including three phase coils of which at least two phase coils are provided with current measuring apparatuses, wherein the harmonic components contained in the two phase currents measured by the current measuring apparatuses are compared with each other, and when the harmonic components differ from each other, it is determined that a ground fault has occurred in a phase coil of the armature winding.

Further, according to this invention, there is provided an electric rotating machine comprising an armature winding including three phase coils; a neutral grounding resistor; a disconnector for an electric braking circuit that connects the ends of the three phase coils on the side of power line and grounds the connected ends; a current detector furnished between the electric braking circuit and the ground; and a ground fault detecting apparatus that detects a ground fault in a phase coil on the basis of the value of the current detected by the current detector.

This invention, which has been designed as described above, has following advantages.

Since the electric rotating machine according to this invention need not resort to the procedures of selecting different preset neutral current values for different machines and of measuring the change in the neutral current, a coil ground fault can be detected without any erroneous operation.

Further, the electric rotating machine according to this invention can detect a coil ground fault even when electric braking is being actuated.

### BRIEF DESCRIPTION OF THE DRAWINGS

Fig. 1 is a wiring diagram for an eclectic rotating machine as a first embodiment of this invention;
Fig. 2 is a wiring diagram for an eclectic rotating machine as a second embodiment of this invention;
Fig. 3 is a wiring diagram for an eclectic rotating machine as a third embodiment of this invention;
Fig. 4 is a wiring diagram for an eclectic rotating machine as a fourth embodiment of this invention;
Fig. 5 is a wiring diagram for an eclectic rotating machine as a fifth embodiment of this invention;
Fig. 6 is a wiring diagram for an eclectic rotating machine as a sixth embodiment of this invention;
Fig. 7 is a wiring diagram for an eclectic rotating machine as a seventh embodiment of this invention;
Fig. 8 is a wiring diagram for an example of a conventional electric rotating machine capable of detecting a ground fault;
Fig, 9 is a wiring diagram for an electric rotating machine as a variation of the fifth embodiment of this invention;
Fig. 10 shows the flow of an operation for detecting a ground fault in the first embodiment of this invention;
Fig. 11 graphically shows current waveforms observed when the electric rotating machine is operating under normal condition;
Fig. 12 graphically shows current waveforms observed when a ground fault occurs in the U-phase coil;
Fig. 13 shows the flow of an operation for detecting a ground fault in the sixth embodiment of this invention;
Fig. 14 a wiring diagram for an eclectic rotating machine as an eighth embodiment of this invention; and
Fig. 15 shows the path through which the ground fault current flows when a ground fault occurs at the time of electric brake actuation.

### DETAILED DESCRIPTION OF EMBODIMENTS

Embodiments of this invention will be described below with reference to the attached drawings.

### [Embodiment 1]

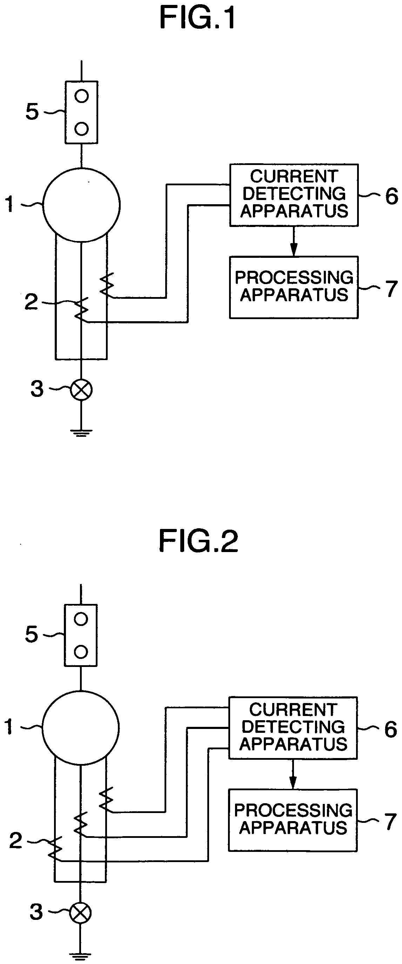

Fig. 1 is a wiring diagram for an eclectic rotating machine as a first embodiment of this invention. In the armature winding of an electric rotating machine 1, the neutral of the three phase coils is grounded through a disconnector 3. Current measuring apparatuses 2 are furnished for the two phase coils of the three-phase armature winding so as to measure currents through the two phase coils. The measured currents for the two phases are detected by a current detecting apparatus 6. A processing unit 7 compares the harmonic components of the two phase currents with each other, and it is decided that a ground fault has occurred in one of the two phase coils if the harmonic components differ from each other.

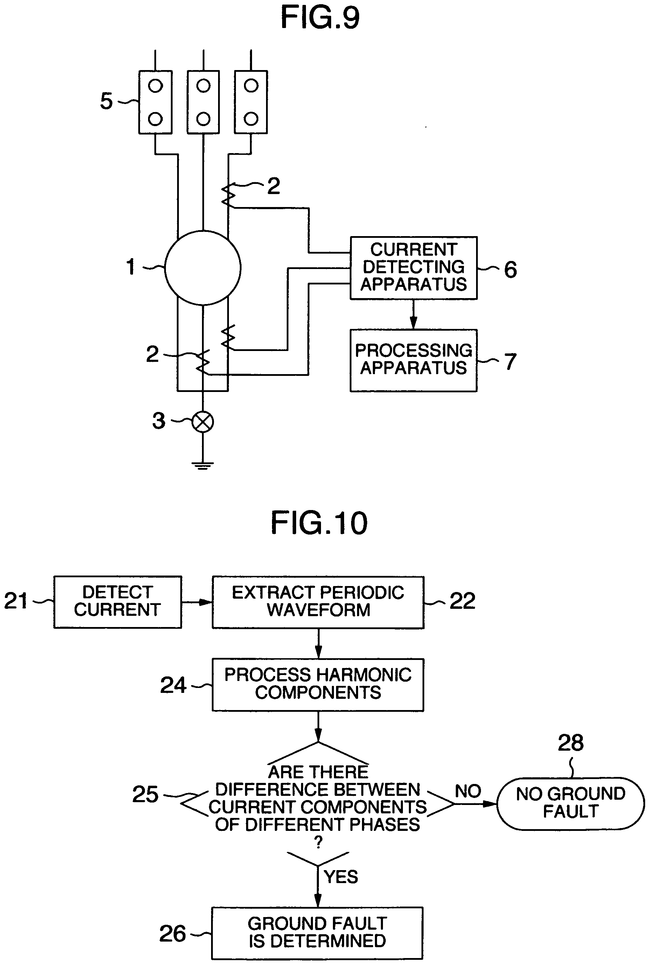

Fig. 10 shows the flow of an operation for detecting a ground fault in the first embodiment of this invention. In Step 21, current detection is performed by means of the current detecting apparatus 6. In Step 22, periodic waveforms are extracted on the basis of the detected information. In Step 24, the comparison of harmonic components is performed in the processing apparatus 7. In Step 25, the difference between two phase currents is checked. If the check result is "YES" (i.e. difference exists), the flow proceeds to Step 26 which indicates that a ground fault has occurred in the armature winding. Or if the check result is "NO" (i.e. no difference exists), the flow proceeds to Step 28 which indicates that there is no ground fault.

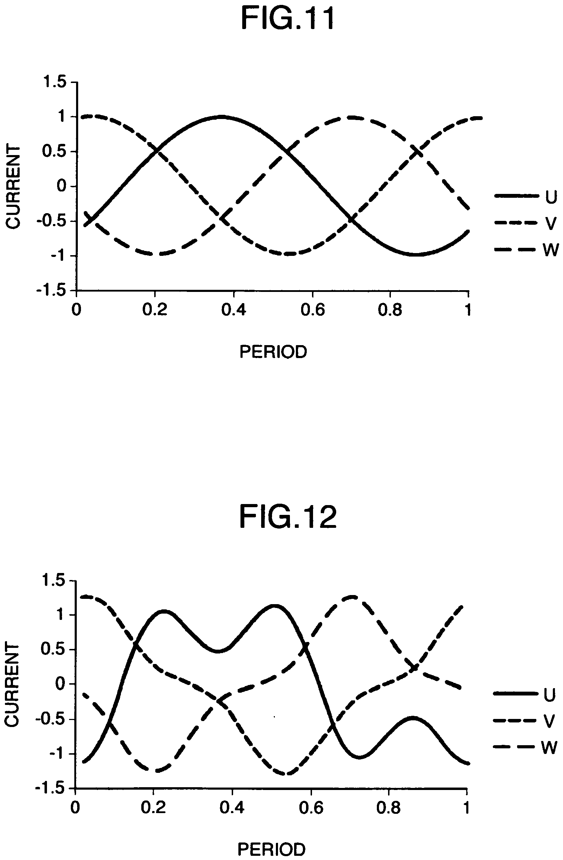

Regarding a three-phase synchronous generator with its output terminals connected with the power system via a transformer, for example, the current waveforms observed when there is no ground fault, hardly contain any harmonic components as shown in Fig. 11. On the other hand, if there is a ground fault in the armature winding, the phase currents contain harmonic components as shown in Fig. 12. This can be ascertained through an analysis.

Fig. 12 shows waveforms in an analytical case where a ground fault occurred in the U-phase coil of the armature winding. The current values in Figs. 11 and 12 are graduated in the normalized scale which sets to 1.0 the current peak value observed when there is no ground fault.

When a ground fault occurs in any phase coil of the armature winding, the zero-phase voltage changes so that the current through the neutral also changes. Alternatively, since a change in the output or the power factor of the generator also causes a change in the neutral current, conventional methods have detected a ground fault occurring in the armature winding by changing the preset value for the third harmonic of the neutral current through the use in analyses of such information as outputs and phase currents.

On the other hand, according to this invention, harmonic components contained in two or more phase currents are used as information for detecting a ground fault in a phase coil of the armature winding. Further, since the ground fault is detected when the harmonic components differ from each other, then the fault can be detected independent of such a preset value as mentioned above. Accordingly, this invention is advantageous in that ground fault detection can be effected free from restrictions on the available detection range affected by erroneous operations or the sensitivity of instruments used for measurement.

It should be noted here that the harmonic components are compared with each other with respect to their amplitudes or phases obtained as a result of the harmonic analysis of the corresponding current waveforms. According to this invention, a ground fault in a phase coil of the armature winding can be detected by detecting the harmonic components even in the case where the fundamentals of the phase currents hardly differ from each other due to high electric resistance developed at the point of the ground fault.

Although the third harmonics resulting from the zero-phase components can be suitably used as harmonic components to be detected, the fifth, seventh, eleventh or twelfth harmonics may also be used for comparison if the third harmonics are not easily detected due to restrictions on instruments or methods employed for measurement.

When the armature current contains harmonics since the electric rotating machine is driven by an inverter, the detection of a ground fault can be effected by detecting an increase in the harmonics from their initial values.

### [Embodiment 2]

Fig. 2 is a wiring diagram for an eclectic rotating machine as a second embodiment of this invention. In the first embodiment described above, two phase currents are compared with each other. However, three phase currents may be measured to detect a ground fault in the armature winding.

### [Embodiment 3]

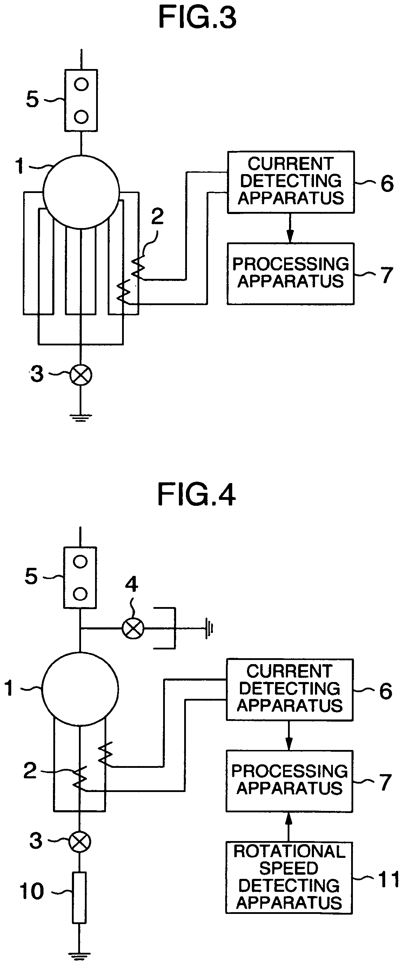

Fig. 3 is a wiring diagram for an eclectic rotating machine as a third embodiment of this invention. In this embodiment, an electric rotating machine 1 includes three-phase coils in the armature winding, each phase coil consisting of three parallel circuits. The two parallel circuits of a phase coil are furnished with current measuring apparatuses 2, and one of the parallel circuits of another phase coil may also be furnished with a current measuring apparatus 2 (not shown). A processing apparatus 7 compares the harmonic components of the currents detected in the two parallel circuits of the same phase coil or in one parallel circuit of a phase coil and one parallel circuit of another phase coil, by the current detecting apparatus 6. Then, the processing apparatus 7 decides that a ground fault has occurred in any of the phase coils of the armature winding if the harmonic components in two different parallel circuits differ from each other.

In a parallel circuit in which a ground fault has occurred, the current due to the ground fault is superposed on the normal operating current flowing through the parallel circuit so that the current waveform in the parallel circuit in question differs from that in other parallel circuits. Accordingly, a ground fault can be detected by comparing current components in two different parallel circuits of the same phase coil or two different parallel circuits belonging to two different phase coils, with each other.

In general, a change in the magnetic flux induced in a parallel circuit by the current due to a ground fault influences the currents and therefore the current waveforms in the other parallel circuits. Consequently, even if a ground fault occurs in a parallel circuit which is not furnished with a current measuring apparatus, the fault can be detected by comparing the waveform of the current in the parallel circuit having the current measuring apparatus furnished therewith, with the waveforms of currents in other parallel circuits.

In this embodiment, two current measuring apparatuses are furnished for two of the three phase coils. Alternatively, however, current measuring apparatuses may be furnished for two or three parallel circuits of each of two or three phase coils.

### [Embodiment 4]

Fig. 4 is a wiring diagram for an eclectic rotating machine as a fourth embodiment of this invention. In general, the electric rotating machine such as the generator-motor for use at the pumped-up hydropower plant is sometimes controlled as follows: the three phase coils of the armature winding are connected together to form the neutral also on the line side of the power system; the thus formed neutral is grounded via a disconnector 4 for electric braking; short-circuit current is caused to flow through the armature winding by conducting field current through the rotor winding; and as a result, mechanical energy of rotation is consumed as electric energy loss, creating braking force.

This embodiment makes it possible to detect a ground fault occurring in the armature winding while the electric rotating machine is working as an electric braking mechanism. The neutral of the armature winding of the electric rotating machine 1, which is formed by connecting the three phase coils of the armature winding together, is grounded via the disconnector 3. Also, the neutral of the armature winding of the electric rotating machine 1, which is formed by connecting the three phase coils of the armature winding together on the power line side, is grounded via the disconnector 4 for electric braking. Two current measuring apparatuses 2 are furnished for two of the three phase coils of the armature winding as shown in Fig. 4 so that currents through the corresponding phase coils can be measured. A processing apparatus 7 performs the process of comparing harmonic components on the basis of the phase currents detected by a current detecting apparatus 6 and the rotational speed detected by a rotational speed detecting apparatus 11. And if there is a difference between the harmonic components of the two phase currents, decision is made that a ground fault has occurred in the armature winding.

According to conventional techniques, it was difficult to detect a ground fault occurring in the armature winding while the electric brake is being applied since a resistor used to ground the neutral has a very large resistance value so that the current flowing from the grounded point to the point of the ground fault during the electric braking is too small to detect. In addition, according to the conventional techniques, armature winding ground faults were detected by processing the neutral current, output current and output voltage of generator. Accordingly, those conventional techniques were not applicable to the detection of a ground fault occurring in the armature winding at the time of electric brake taking place where the three phase coils are short-circuited and the voltage at the neutral vanishes.

According to this invention, on the other hand, phase currents can be measured by means of the current measuring apparatuses 2 even at the time of electric brake taking place when the three phase coils are short-circuited, and the harmonic components of the phase currents can be compared with each other, so that a ground fault occurring in the armature winding can be detected. This is an advantage of this invention over the conventional techniques.

### [Embodiment 5]

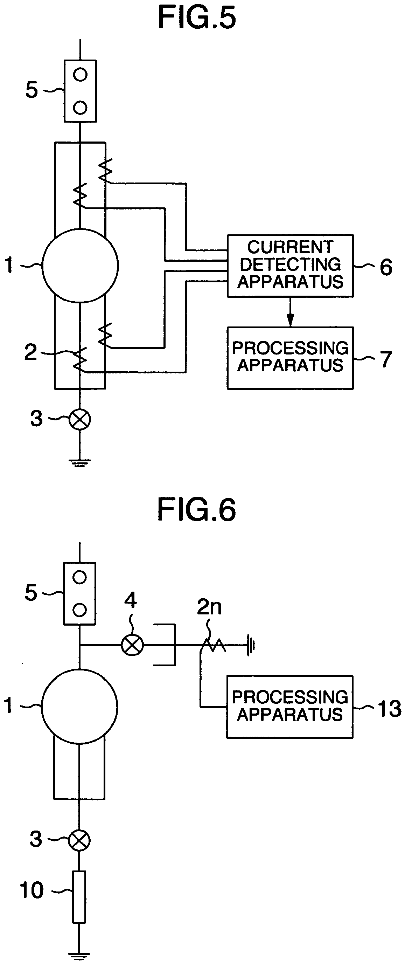

Fig. 5 is a wiring diagram for an eclectic rotating machine as a fifth embodiment of this invention. As shown in this wiring diagram, current measuring apparatuses 2 are furnished on the power line side as well as on the side of the neutral of the armature winding.

In the phase coil in which a ground fault occurred, current due to the ground fault is superposed on the current that flows through the same phase coil under the normal condition without any ground fault. As a result, the current waveform on the side of the neutral differs from the current waveform on the power line side. Consequently, the harmonic components on the neutral side and the power line side can be compared with each other in addition to the harmonic components in different phase coils on the neutral side, so that precision in detecting armature winding ground faults can be enhanced and also that the phase coil of the armature winding in which a ground fault has occurred can be located. This is another advantage of this invention over the conventional techniques.

In this embodiment, current measuring apparatuses 2 are furnished for two of the three phase coils. However, current measuring apparatuses 2 may be furnished for only a phase coil, or for all the three phase coils.

Alternatively, as shown in Fig. 9, when three circuit breakers 5 are furnished for the respective phase lines of the power system, a current measuring apparatus 2 on the power line side should preferably be placed between the electric rotating machine 1 and the circuit breaker 5. Further, any number of phases can be selected for detection of difference between current component on the power line side and current component on the neutral side.

### [Embodiment 6]

Fig. 6 is a wiring diagram for an eclectic rotating machine as a sixth embodiment of this invention. An electric rotating machine 1 includes an armature winding consisting of three phase coils; a current detector 2n is furnished between the neutral of an electric braking circuit and the ground; and a processing apparatus 13 decides that a ground fault occurring in the armature winding has been detected, when the value of the current detected by the current detector 2n has exceeded an initial value.

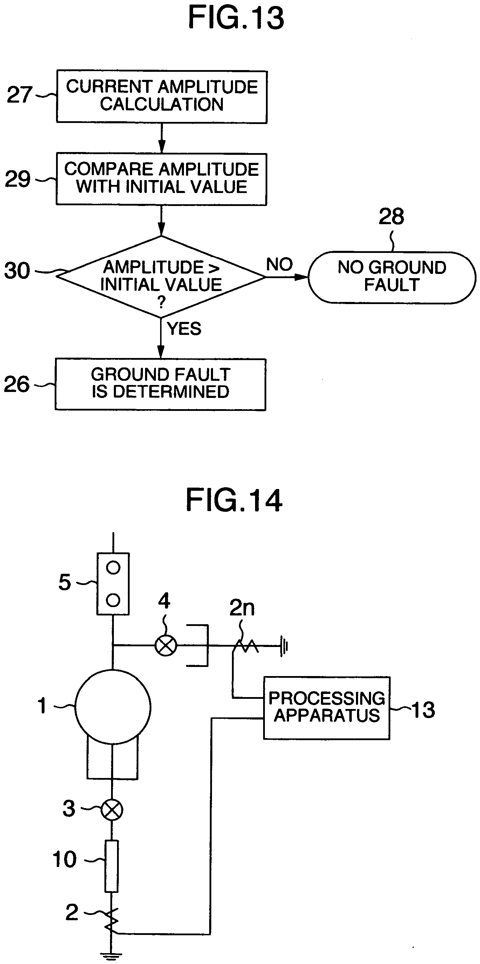

Fig. 13 shows the flow of an operation for detecting a ground fault occurring in the armature winding in the sixth embodiment of this invention. In Step 27, the amplitude of the current detected by the current detector 2n is calculated in the processing apparatus 13, and the calculated amplitude is compared with the initial value in Step 29. In Step 30, it is checked whether or not the amplitude is greater than the initial value. If the amplitude is greater than the initial value, the flow proceeds to Step 26, where a ground fault detecting and determining procedure is performed. If the situation is to the contrary, the flow proceeds to Step 28, where it is determined that no ground fault is occurring in the armature winding.

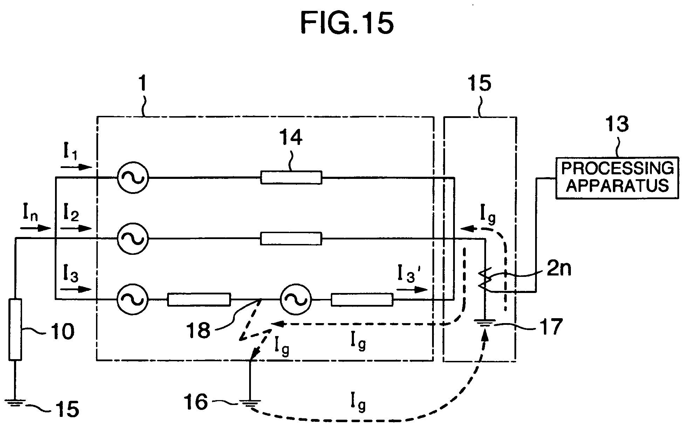

Fig. 15 shows a path represented by dashed line through which the ground fault current Ig flows when a ground fault occurs in the armature winding of an electric rotating machine 1 at the time of electric brake taking place. Since a grounding resistor 10 connected between the neutral and the ground point 15 usually has a very great resistance value, the current flowing at the time of a ground fault occurring in a phase coil, from the ground point 15 associated with the neutral to the ground point 16 associated with the ground fault, is very small. On the other hand, unless a resistor having a very great resistance value is inserted between the neutral on the side of an electric braking circuit and the associated ground point 17, it is foreseen that when a ground fault occurs, a relatively large ground fault current flows through the phase coil 18 in which the ground fault has occurred, the ground point 16 associated with the ground fault and the ground point 17 associated with the neutral in the electric braking circuit. This ground fault current is apparently a large current as compared with the current flowing through the phase coil 18 under normal condition free from a ground fault, so that it is easy for the current detector 2n to detect such a large current.

In fact, as described in this embodiment, a ground fault occurring in a phase coil at the time of electric braking action taking place can be detected by furnishing a current detecting apparatus near the ground point on the side of an electric braking circuit.

### [Embodiment 7]

Fig. 7 is a wiring diagram for an eclectic rotating machine as a seventh embodiment of this invention. In an electric rotating machine 1, the three phase coils of the armature winding are connected together to form a neutral, and the neutral is grounded via a disconnector 3. On the side of the power line, too, the three phase coils of the armature winding are connected together to form a neutral, and this neutral, too, are grounded via a disconnector 4 furnished for an electric braking circuit. Current measuring apparatuses 2 are furnished for two of the three phase coils on the side of the disconnector 3. A processing apparatus 7 compares with each other the harmonic components of the two phase currents detected by the current detecting apparatus 6. If there is difference between the harmonic components of the two phase currents, it is determined that a ground fault has occurred in a phase coil. Further, a current detector 2n is furnished between the disconnector 4 and the ground. This design makes it possible to detect a ground fault by comparing the value of the current detected by the current detector 2n with a preset value as well as comparing with each other the harmonic components of the two phase currents measured by the current measuring apparatuses 2.

Since a grounding resistor connected between the neutral and the ground point usually has a very great resistance value, the current flowing at the time of a ground fault occurring in a phase coil, from the ground point associated with the neutral to the ground point associated with the ground fault, is very small. On the other hand, unless a resistor having a very great resistance value is inserted between the neutral on the side of an electric braking circuit and the associated ground point, it is foreseen that a relatively large current flows between the ground point on the side of the electric braking circuit and the point of the ground fault when a ground fault occurs in a phase coil. This ground fault current differs very much from the current flowing through the phase coil under normal condition free from a ground fault, so that it is easy to determine that there is a ground fault.

Thus, as described in this embodiment, precision in detecting a ground fault in a phase coil can be enhanced when information on the current detected near the ground point on the side of the electric braking circuit is additionally utilized.

### [Embodiment 8]

Fig. 14 is a wiring diagram for an eclectic rotating machine as an eighth embodiment of this invention. An electric rotating machine 1 has an armature winding consisting of three phase coils; a current measuring apparatus 2 is furnished between the ground and a grounding resistor 10 connected via a disconnector 3 coupled to the neutral of the three phase coils; and a current detector 2n is furnished between the ground and the neutral in the braking circuit. Accordingly, a processing apparatus 13 determines that a ground fault has occurred in a phase coil when the difference between the current measured by the current measuring apparatus 2 and the current detected by the current detector 2n exceeds an initial value.

Since a grounding resistor connected between the neutral and the ground point usually has a very great resistance value, the current flowing at the time of a ground fault occurring in a phase coil, from the ground point associated with the neutral to the ground point associated with the ground fault, is very small. On the other hand, unless a resistor having a very great resistance value is inserted between the neutral on the side of an electric braking circuit and the associated ground point, it is foreseen that a relatively large current flows between the ground point on the side of the electric braking circuit and the point of the ground fault when a ground fault occurs in a phase coil. Therefore, there is a remarkable difference between the current measured by the current measuring apparatus 2 and the current detected by the current detector 2n.

## Claims

1. An electric rotating machine (1) having an armature winding including three phase coils of which at least two phase coils are provided with current measuring apparatuses (2), wherein harmonic components contained in two phase currents measured by the current measuring apparatuses (2) are compared with each other, and when the harmonic components differ from each other, it is determined that a ground fault has occurred in a phase coil of the armature winding.

2. An electric rotating machine (1) as claimed in Claim 1, wherein the amplitudes of third harmonic components contained in the two phase currents measured by the current measuring apparatuses (2) are compared with each other.

3. An electric rotating machine (1) as claimed in Claim 1, wherein the armature winding includes a plurality of parallel circuits; current measuring apparatuses (2) are furnished for at least two of the parallel circuits on the side of the neutral of the armature winding; and a phase coil grounding fault is detected by comparing harmonic components contained in the currents through the parallel circuits for which the current measuring apparatuses (2) are furnished.

4. An electric rotating machine (1) as claimed in Claim 1, further including a grounding resistor (10) connected at a neutral of the armature winding; and an electric braking circuit furnished on the side of power line so as to provide a three-phase short-circuiting and a grounding path, wherein a phase coil grounding fault is detected if the harmonic components contained in the two phase currents differ from each other when the electric braking circuit is being actuated.

5. An electric rotating machine having an armature winding including three-phase coils, comprising a grounding resistor (10) connected at a neutral of the armature winding, current measuring apparatuses (2) furnished on the neutral side of the armature winding, and a current measuring apparatus (2n) furnished on the power line side of the armature winding, wherein harmonic components contained in phase currents measured by the current measuring apparatuses (2, 2n) are compared with each other, and when the harmonic components differ from each other, it is determined that a coil ground fault has occurred.

6. An electric rotating machine having an armature winding including three-phase coils, comprising a grounding resistor (10) connected at a neutral of the armature winding, an electric braking circuit furnished on the side of power line so as to provide a three-phase short-circuiting and a grounding path, and a current detector (2n) furnished between a neutral of the electric braking circuit and the ground, wherein the detection of a coil ground fault is determined on the basis of the value of current detected by the current detector (2n).

7. An electric rotating machine as claimed Claim 6, further comprising a grounding resistor (10) connected at a neutral of the armature winding, an electric braking circuit furnished on the side of power line so as to provide a three-phase short-circuiting and a grounding path, a current detector (2) furnished between the neutral grounding resistor (10) and the ground, and a current detector (2n) furnished between a neutral of the electric braking circuit and the ground, wherein the detection of a coil ground fault is determined on the basis of difference between the values of currents detected by the current detectors (2, 2n).
